# EUROPÄISCHE PATENTANMELDUNG

(11) **EP 1 187 180 A1**
(43) Veröffentlichungstag der Anmeldung: **13.03.2002**
(21) Anmeldenummer: 00810820.1
(22) Anmeldetag: 12.09.2000
(51) Int. Cl.: H01L 21/00

(54) **Verfahren und Vorrichtung für die Montage von Halbleiterchips**

(71) Anmelder: Esec Trading S.A., 6330 Cham (CH)
(72) Erfinder: Leu, Felix, 6300 Zug (CH)
(74) Vertreter: Falk, Urs, Dr.

(57) **Zusammenfassung**

Bei der Montage eines Halbleiterchips (1) auf einem eine Portion Klebstoff (5) aufweisenden Substrat (4) wird der Bondkopf (3) auf eine vorbestimmte Höhe H über einer das Substrat (4) aufnehmenden Auflage (6) abgesenkt. Dabei ist der Greifer (2) in einer oberen Endposition am Bondkopf (3) fixiert. Sobald der Bondkopf (3) die Höhe H erreicht hat, wird die Fixierung des Greifers (2) gelöst, so dass sich der Greifer (2) von der oberen Endposition nach unten bewegt und den Halbleiterchip (1) auf den Klebstoff (5) drückt. Nach einer vorbestimmten Zeitspanne nach dem Lösen der Fixierung des Greifers (2) wird der Bondkopf (3) angehoben und weggefahren.
Bei einem für das Verfahren besonders geeigneten Bondkopf(3) sind der Greifer (2) und der Bondkopf (3) durch eine mit Druckluft und/oder Vakuum beaufschlagbare Kammer (12) verbunden, so dass die Bewegung des Greifers (2) weitgehend kontrolliert werden kann.

## Beschreibung

Die Erfindung betrifft ein Verfahren und eine Vorrichtung für die Montage von Halbleiterchips der im Oberbegriff des Anspruchs 1 genannten Art.

Bei der Montage der Halbleiterchips wird das Substrat von einer Transporteinrichtung taktweise einer Dispensstation, wo Klebstoff aufgetragen wird, und dann einer Bondstation zugeführt, wo der nächste Halbleiterchip plaziert wird. Mit zunehmender Miniaturisierung der elektronischen Strukturen werden auch die Halbleiterchips für gewisse Anwendungen sehr klein. Die Abmessungen der kleinsten Halbleiterchips betragen bereits weniger als 0.2 mm * 0.2 mm. Wenn die Klebstoffschicht zwischen dem Substrat und dem Halbleiterchip aus einem elektrisch leitenden Klebstoff besteht, stellt sich die Aufgabe, die winzigen Halbleiterchips so auf dem Substrat zu montieren, dass die Dicke der Klebstoffschicht zwischen dem Substrat und dem Halbleiterchip nach dem Aushärten gleichmässig ist und nur innerhalb eng vorgegebener Toleranzen, beispielsweise von nur ±5µm schwankt. Nur so kann eine gleichbleibend hohe Qualität der elektrischen Eigenschaften der montierten Halbleiterchips erreicht werden. Zudem wird verlangt, dass Substrate verschiedener Hersteller verwendet werden können, was bedeutet, dass die Dicke der zu verarbeitenden Substrate Schwankungen von typisch 60 bis 70µm unterliegt.

Zum Ausgleich der Dickenschwankungen der Substrate wird heute ein allgemein als "Overtravel" bekanntes Verfahren verwendet. Der Montageautomat, ein sogenannter Die Bonder, enthält einen Bondkopf mit einem Greifer zum Ergreifen des Halbleiterchips. Der Bondkopf wird auf eine vorbestimmte Höhe über dem Substrat abgesenkt, die so eingestellt ist, dass der Halbleiterchip in jedem Fall, unabhängig von der aktuellen Dicke des Substrates, auf der Klebstoffportion auftrifft. Dabei wird einerseits der Klebstoff zusammengedrückt und andererseits der Greifer gegenüber dem Bondkopf ausgelenkt. Die Dicke der resultierenden Klebstoffschicht unterliegt grossen Schwankungen.

Der Erfindung liegt die Aufgabe zugrunde, ein Verfahren und eine Vorrichtung für die Montage von winzigen Halbleiterchips anzugeben, das die oben genannten Anforderungen erfüllt.

Die genannte Aufgabe wird erfindungsgemäss gelöst durch die Merkmale des Anspruchs 1.

Die Lösung der Aufgabe gelingt mit einem Verfahren, bei dem der Halbleiterchip unter kontrollierten Bedingungen auf die Klebstoffportion aufgebracht wird. Entscheidend für das Erreichen einer Klebstoffschicht mit geringen Dickenschwankungen ist, dass der Aufprall des Halbleiterchips auf die Klebstoffportion gegenüber dem Stand der Technik deutlich verkleinert wird. Dies wird dadurch erreicht, dass nicht der Halbleiterchip und der ganze Bondkopf auf dem Klebstoff aufprallen, sondern nur der Halbleiterchip und ein kleiner Teil des Bondkopfes, nämlich der Greifer, an dessen Spitze sich der Halbleiterchip befindet.

Das erfindungsgemässe Verfahren und Ausführungsbeispiele von zur Durchführung des Verfahrens geeigneten Vorrichtungen werden nun anhand der Zeichnung näher erläutert.

Es zeigen:
- Fig. 1A, B: zwei Stufen des erfindungsgemässen Verfahrens,
- Fig. 2: ein Diagramm,
- Fig. 3, 4: Details von zur Durchführung des Verfahrens geeigneten Vorrichtungen, und
- Fig. 5: weitere Teile der Vorrichtung nach Fig. 4.

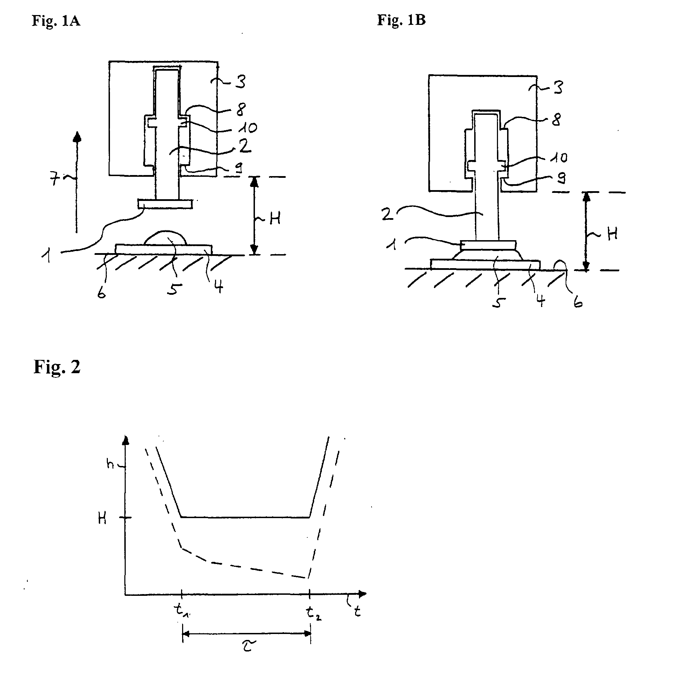

Die Fig. 1A und 1B zeigen aufeinanderfolgende Phasen des erfindungsgemässen Verfahrens. Die beiden Figuren zeigen einen Halbleiterchip 1, einen Greifer 2, einen Bondkopf 3, ein Substrat 4, eine Portion Klebstoff 5 und eine Auflage 6 für das Substrat 4. Der Greifer 2 ist ein Teil des Bondkopfes 3. Der Greifer 2 ist in vertikaler Richtung 7 zwischen einer oberen Endposition und einer unteren Endposition verschiebbar, die beispielsweise durch einen mit Anschlagsflächen 8 bzw. 9 zusammenwirkenden Nocken 10 am Greifer 2 definiert sind. Der Greifer 2 ist frei verschiebbar, d.h. der Verschiebung des Greifers 2 wirkt keine Feder entgegen.

Bei der Montage des Halbleiterchips 1 wird der Bondkopf 3 in einem ersten Schritt auf eine vorbestimmte Höhe H über der Auflage 6 abgesenkt, wobei sich der Greifer 2 in der oberen Endposition befindet. Dieser Zustand ist in der Fig. 1A dargestellt. Die Höhe H ist entsprechend der grössten zu erwartenden Dicke des Substrats 4 und der grössten Höhe H₁ des Klebstoffes 5 so vorbestimmt, dass der Halbleiterchip 1, der sich an der Spitze des Greifers 2 befindet, den Klebstoff 5 in der Regel noch nicht berührt oder nur so berührt, dass die Klebstoffportion nur unwesentlich verformt wird.

Der Bondkopf 3 verharrt nun auf der Höhe H. Die Befestigung des Greifers 2 am Bondkopf 3 wird nun in einem zweiten Schritt gelöst, so dass sich der Greifer 2 infolge der Schwerkraft absenkt. Der Halbleiterchip 1 prallt auf dem Klebstoff 5 auf und sinkt tiefer und tiefer in den Klebstoff 5 ein, wobei sich die Dicke der Klebstoffschicht zunehmend verkleinert. Der Klebstoff 5 setzt seiner Verformung und damit dem Absinken des Halbleiterchips 1 zwar einen gewissen Widerstand entgegen, vermag aber das Gewicht des Greifers 2 nicht zu kompensieren. Um das Absinken des Halbleiterchips 1 zu stoppen, muss der Bondkopf 3 weggefahren werden. Das Wegfahren des Bondkopfes 3 erfolgt deshalb in einem dritten Schritt um eine vorbestimmte Zeitspanne τ nach dem Lösen des Greifers 2.

Der Zustand unmittelbar vor dem Wegfahren des Bondkopfes 3 ist in der Fig. 1B dargestellt. Die Fallzeit des Greifers 2 vom Zeitpunkt seiner Loslösung vom Bondkopf 3 bis zum ersten Berühren des Klebstoffs 5 ist kurz gegenüber der Zeitspanne τ. Somit wird eine von der aktuellen Dicke des Substrats 4 praktisch unabhängige Schichtdicke des Klebstoffs 5 erreicht. Der Aufprall des Halbleiterchips 1 auf dem Klebstoff 5 ist, bei reibungsloser Führung des Greifers 2 am Bondkopf 3, proportional zur Masse von Halbleiterchip 1 und Greifer 2 und damit wesentlich geringer als beim zitierten "Overtravel" Verfahren.

Zudem bewirkt die auf die Masse des Greifers 2 reduzierte Masse ein langsameres Absinken des Halbleiterchips 1 auf dem Klebstoff 5.

Die Fig. 2 zeigt mit ausgezogener Linie den Verlauf der Höhe h des Bondkopfes 3 über der Auflage 6 und mit gestrichelter Linie den Verlauf der Höhe h des Greifers 2 über der Auflage 6 in Verlauf der Zeit t. Der Bondkopf 3 erreicht zum Zeitpunkt t₁ die Höhe H, verharrt während der Zeitspanne τ auf der Höhe H und fährt zum Zeitpunkt t₂ ohne Halbleiterchip wieder weg. Der Greifer 2 ist bis zum Erreichen der Höhe H in seiner oberen Endposition am Bondkopf 3 fixiert, senkt sich nach seiner Lösung vom Bondkopf 3 bis er auf dem Klebstoff 5 auftrifft etwas schneller und sinkt dann etwas langsamer in den Klebstoff 5 ein.

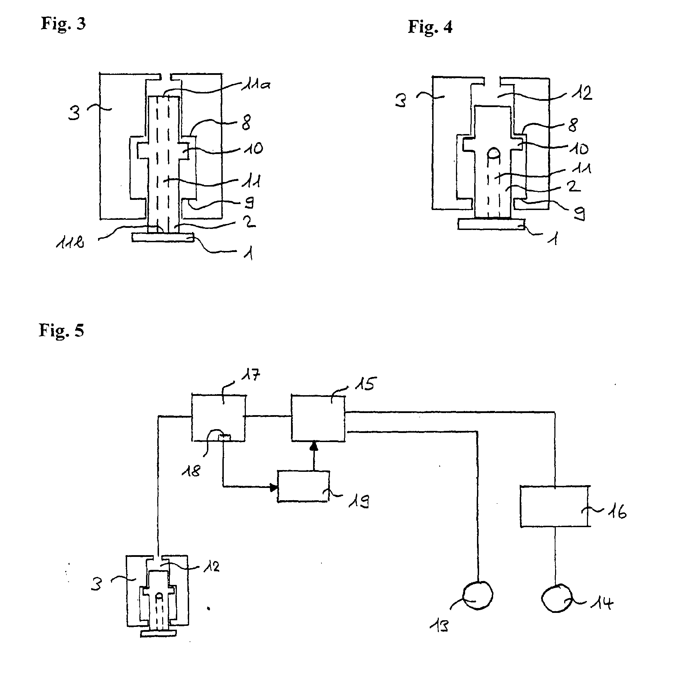

Die Fig. 3 zeigt Details einer ersten Vorrichtung zur Durchführung des erfindungsgemässen Verfahrens. Bei dieser Vorrichtung weist der Greifer 2 eine durchgehende Längsbohrung 11 auf, deren oberes Ende zum Ergreifen des Halbleiterchips 1 mit Vakuum beaufschlagt werden kann. Beim Ergreifen des Halbleiterchips 1 wird die Längsbohrung 11 am unteren Ende abgedichtet. Dabei baut sich infolge des Druckunterschiedes zwischen dem unteren und dem oberen Ende der Längsbohrung 11 eine nach oben gerichtete Kraft auf, die ausreicht, um den Greifer 2 in die obere Endposition zu befördern: Der Greifer 2 wird auf diese Weise in der oberen Endposition am Bondkopf 3 fixiert.

Nachdem der Bondkopf 3 die in der Fig. 1A gezeigte Lage erreicht hat, wird das Vakuum am oberen Ende der Längsbohrung 11 abgeschaltet. Die auf den Greifer 2 einwirkende, nach oben gerichtete Kraft, wird mit zunehmender Verkleinerung des Vakuums zunehmend kleiner: Der Greifer 2 fällt nach unten, der Halbleiterchip 1 trifft auf den Klebstoff 5 auf und drückt den Klebstoff 5 immer mehr zusammen, bis der Bondkopf 3 nach der Zeitspanne τ angehoben und weggefahren wird. Solange das Vakuum nicht gänzlich abgebaut ist, haftet der Halbleiterchip 1 noch am Greifer 2. Das Aufsetzen des Halbleiterchips 1 auf dem Klebstoff 5 erfolgt also kontrolliert unter Führung des Greifers 2. Nach Ablauf der Zeitspanne τ hat sich auch das Vakuum genügend abgebaut, so dass der Bondkopf 3 beim Abheben den Halbleiterchip 1 auf dem Klebstoff 5 zurücklässt.

Die Fig. 4 zeigt Details einer zweiten Vorrichtung zur Durchführung des erfindungsgemässen Verfahrens. Bei dieser Vorrichtung sind die Funktionen "Halten des Bauteils " und "Fallenlassen des Greifers 2" getrennt. Der Bondkopf 3 enthält eine mit Druckluft oder Vakuum beaufschlagbare Kammer 12, in der das obere Ende des Greifers 2 luftdicht gelagert ist. Wenn die Kammer 12 mit Vakuum beaufschlagt wird, dann wird der Greifer 2 in seine obere Endposition befördert. Wenn die Kammer 12 mit Druckluft beaufschlagt wird, dann wird der Greifer 2 in seine untere Endposition befördert. Der Greifer 2 weist zudem eine Längsbohrung 11 auf, die mit einer Vakuumquelle verbindbar ist.

Zum Ergreifen des Halbleiterchips 1 wird die Kammer 12 mit Druckluft beaufschlagt, wobei der Druck in der Kammer 12 auf einen vorbestimmten Wert p₁ geregelt wird. Beim Ergreifen des Halbleiterchips 1 wird der Bondkopf 3 soweit abgesenkt, dass die sich zwischen dem Halbleiterchip 1 und dem Greifer 2 aufbauende Kraft ausreicht, um den Greifer 2 aus seiner unteren Endposition auszulenken. Diese Kraft F₁ ist unabhängig vom Grad der Auslenkung. Sie ist bestimmt durch die Querschnittsfläche A, auf der der Druck p₁ in der Kammer 12 auf den Greifer 2 einwirkt: F₁ = p₁ * A. Spätestens jetzt wird die Längsbohrung 11 mit Vakuum beaufschlagt, so dass der Halbleiterchip 1 am Greifer 2 haftet und aufgenommen werden kann.

Nachdem der Halbleiterchip 1 ergriffen wurde, wird die Kammer 12 mit Vakuum beaufschlagt, um den Greifer 2 in seine obere Endposition zu befördern. Wie beim ersten Ausführungsbeispiel wird der Bondkopf 3 nun zum Substrat 4 (Fig. 1A) transportiert und im ersten Schritt auf die vorbestimmte Höhe H über der Auflage 6 abgesenkt. Der Bondkopf 3 verharrt nun auf der Höhe H. Nun wird das Vakuum in der Kammer 12 aufgehoben, so dass sich der Greifer 2 gegenüber dem Bondkopf 3 absenkt. Der Bondkopf 3 verharrt während der Zeitspanne τ auf der Höhe H, die mit dem Zeitpunkt des Aufhebens des Vakuums beginnt und mit dem Abheben und Wegfahren des Bondkopfs 3 endet. Diese Verweildauer τ des Bondkopfs 3 auf der Höhe H bestimmt, wie weit der Halbleiterchip 1 den Klebstoff 5 zusammendrückt, d.h. welche Klebstoffdicke erreicht wird. Damit der Bondkopf 3 ohne den gebondeten Halbleiterchip 1 wegfahren kann, muss das Vakuum in der Längsbohrung 11 rechtzeitig vor Ablauf der Verweildauer τ aufgehoben werden.

Dieses zweite Ausführungsbeispiel hat den Vorteil. dass die Stärke des Vakuums bzw. Unterdrucks in der Kammer 12 während der Zeitspanne τ gemäss einem vorgegebenen Druckprofil geregelt werden kann, so dass das Absinken des Halbleiterchips 1 auf dem Klebstoff 5 mit kontrollierter Geschwindigkeit erfolgt. Insbesondere kann die Absinkgeschwindigkeit gegenüber dem Fall des schlagartigen Aufhebens des Vakuums verkleinert werden.

Das zweite Ausführungsbeispiel eignet sich zudem für die Plazierung relativ grosser Halbleiterchips auf einem Substrat 4, wo gewünscht wird, dass der Halbleiterchip 1 mit einer vorbestimmten Bondkraft auf das Substrat gedrückt wird. Die Kammer 12 wird während des Transports des Bondkopfs 3 zum Substrat 4 hin mit einem vorbestimmten Überdruck p₂ beaufschlagt. Der Überdruck p₂ und die Höhe H₁ über der Auflage 6, auf die der Bondkopf 3 abgesenkt wird, sind so gewählt, dass der Greifer 2 gegenüber dem Bondkopf 3 in vertikaler Richtung 7 nach oben ausgelenkt wird, wobei der Nocken 10 weder oben an der Anschlagsfläche 8 noch unten an der Anschlagsfläche 9 anschlägt. Der Halbleiterchip 1 wird dann mit definierter Bondkraft F₂ = p₂ * A auf den Klebstoff 5 gedrückt, wobei die vom Greifer 2 auf den Halbleiterchip 1 ausgeübte Bondkraft F₂ unabhängig von der Dicke des Substrates ist. Die sich einstellende Schichtdicke des Klebstoffs 5 hängt ab vom Volumen der aufgetragenen Klebstoffportion und vom Druck p₂.

Die Fig. 5 zeigt eine Vorrichtung für die Regelung des Druckes in der Kammer 12 des Bondkopfes 3. Die Vorrichtung weist eine Druckluftquelle 13 und eine Vakuumquelle 14 auf, die mit einem Proportionalventil 15 verbunden sind. Die Vakuumquelle 14 ist bevorzugt über ein Vakuumreservoir 16 mit dem Proportionalventil 15 verbunden. Der Ausgang des Proportionalventils 15 ist mit einer Druckkammer 17 verbunden, deren Volumen mindestens zehn mal grösser als das Volumen der Kammer 12 ist, wenn sich der Greifer 2 in der unteren Endposition befindet. In der Druckkammer 17 befindet sich ein Drucksensor 18 für die Messung des darin herrschenden Druckes p. Das vom Drucksensor 18 gelieferte Signal wird einem Regelgerät 19 zugeführt, das das Proportionalventil 15 so steuert, dass der Druck p in der Druckkammer 17 einem vorgegebenen Wert entspricht. Die Druckkammer 17 ist mit der Kammer 12 des Bondkopfes 3 verbunden, so dass sich in der Kammer 12 der gleiche Druck wie in der Druckkammer 17 einstellt. Über ein nicht dargestelltes schaltbares Ventil ist die Längsbohrung 11 des Greifers 2 separat mit der Vakuumquelle 14 verbindbar zum Ergreifen und Loslassen des Halbleiterchips 1.

## Patentansprüche

1. Verfahren für die Montage eines Halbleiterchips (1) auf einem eine Portion Klebstoff(5) aufweisenden Substrat (4), **gekennzeichnet durch die folgenden Schritte:**
a) Bereitstellen des mit einer Portion Klebstoff (5) versehenen Substrates (4) auf einer Auflage (6);
b) Ergreifen des Halbleiterchips (1) mittels eines an einem Bondkopf (3) in vertikaler Richtung zwischen einer oberen Endposition und einer unteren Endposition verschiebbaren Greifers (2);
c) Absenken des Bondkopfes (3) auf eine vorbestimmte Höhe über der Auflage (6), wobei der Greifer (2) in der oberen Endposition am Bondkopf (3) fixiert ist,
d) Lösen der Fixierung des Greifers (2), so dass sich der Greifer (2) von der oberen Endposition in Richtung der unteren Endposition bewegt und den Halbleiterchip (1) auf den Klebstoff (5) drückt; und
e) Anheben und Wegfahren des Bondkopfes (3) um eine vorbestimmte Zeitspanne nach dem Lösen der Fixierung des Greifers (2).

2. Verfahren nach Anspruch 1, **dadurch gekennzeichnet, dass** die Fixierung des Greifers (2) am Bondkopf(3) mittels Vakuum erfolgt.

3. Verfahren nach Anspruch 1 oder 2, **dadurch gekennzeichnet, dass** der Greifer (2) über eine mit Vakuum beaufschlagbare Kammer (12) am Bondkopf (3) gelagert ist und dass die Stärke des Vakuums gemäss einem vorgegebenen Profil gesteuert wird, um die Bewegung des Greifers (2) von der oberen Endposition in Richtung der unteren Endposition zu steuern.

4. Vorrichtung für die Montage eines Halbleiterchips (1) auf einem eine Portion Klebstoff (5) aufweisenden Substrat (4), mit einem Bondkopf (3) mit einem Greifer (2), **dadurch gekennzeichnet, dass** der Greifer (2) in vertikaler Richtung zwischen einer oberen Endposition und einer unteren Endposition frei verschiebbar ist und dass der Greifer (2) in der oberen Position fixierbar ist.

5. Vorrichtung nach Anspruch 4, **dadurch gekennzeichnet, dass** die Fixierung des Greifers (2) mittels Vakuum erfolgt.

6. Vorrichtung für die Montage eines Halbleiterchips (1) auf einem eine Portion Klebstoff (5) aufweisenden Substrat (4), mit einem Bondkopf (3) mit einem Greifer (2), **dadurch gekennzeichnet, dass** der Bondkopf (3) eine mit Druckluft und/oder Vakuum beaufschlagbare Kammer (12) enthält, in der das obere Ende des Greifers (2) luftdicht gelagert ist, dass der Greifer (2) in vertikaler Richtung zwischen einer oberen Endposition und einer unteren Endposition verschiebbar ist, und dass die Spitze des Greifers (2) mit einer Vakuumquelle verbindbar ist.

7. Vorrichtung nach Anspruch 6, **dadurch gekennzeichnet, dass** der Greifer (2) in der oberen Position fixierbar ist.

8. Vorrichtung nach Anspruch 6 oder 7, **dadurch gekennzeichnet, dass** die Kammer (12) mit einer Druckkammer (17) verbunden ist, deren Volumen mindestens zehn mal grösser als das Volumen der Kammer (12) ist.
